# EUROPEAN PATENT APPLICATION

(11) **EP 4 687 170 A1**
(43) Date of publication of application: **04.02.2026**
(21) Application number: 24191992.7
(22) Date of filing: 31.07.2024
(51) Int. Cl.: H01L 21/56, H01L 23/31, H01L 23/373, H01L 25/07

(54) **POWER SEMICONDUCTOR MODULE AND METHOD FOR MANUFACTURING A POWER SEMICONDUCTOR MODULE**

(71) Applicant: Hitachi Energy Ltd, 8050 Zürich (CH)
(72) Inventor: SANTOLARIA, Lluis, 4600 Olten (CH); TRUESSEL, Dominik, 5620 Bremgarten (CH); MALEKI, Milad, 5417 Untersiggenthal (CH); ZHANG, Biwei, 5600 Lenzburg (CH)
(74) Representative: Epping - Hermann - Fischer

(57) **Abstract**

A power semiconductor module (100) is provided, comprising a substrate (10), having a first main surface (11) and a second main surface (12) opposite the first main surface (11) along a stacking direction (S1). The power semiconductor module (100) further comprises a first circuit metallization (20) with a first portion (21) and a second portion (22), arranged on the first main surface (11). The power semiconductor module (100) further comprises a metal coating (30) arranged in the first portion (21) of the first circuit metallization (20) and a resin body (40) covering the substrate (10) and the second portion (22) of the first circuit metallization (20). The resin body (40) has a top surface (41) extending along a first extension area (A1), and an inner surface (42) facing the first circuit metallization (20). The resin body (40) comprises at least one opening (45) extending into the resin body (40) from the top surface (41) to the inner surface (42) along the stacking direction (S1) and terminates at the metal coating (30), such that the metal coating (30) is exposed.

## Description

The present disclosure relates to a power semiconductor module. The present disclosure relates further to a method for manufacturing the power semiconductor module.

In the manufacturing of molded power packages there are different ways to realize a molded power package with vertically arranged terminals, like auxiliary terminals.

It is an object to provide a power semiconductor module, which has an improved structure while maintaining an efficient manufacturing process with a sufficient process stability.

This object is solved by the features of the independent claims. Advantageous embodiments are indicated in the dependent claims.

Embodiments of the disclosure, for instance as claimed in the independent claims, address the above shortcomings in the art in whole or in part. Further embodiments of the power semiconductor module and of the method for manufacturing the power semiconductor module are subject matter of the further claims.

There is provided a power semiconductor module. The power semiconductor module comprises a substrate, having a first main surface and a second main surface. The second main surface is opposite the first main surface along a stacking direction. Exemplarily, the substrate comprises chips. For example, the chips are arranged on the first main surface. The substrate is for example isolating. The substrate is for example realized by a ceramic based substrate made of an electrically isolating ceramic sheet with a first top metallization on the first main surface and a second bottom metallization on the second main surface.

The substrate is for example realized by an insulated metal substrate comprising a thick metal plate, an electrically isolating resin layer, and a circuit metallization.

The power semiconductor module further comprises a first circuit metallization with a first portion and a second portion. The first circuit metallization is arranged on the first main surface of the substrate. Exemplarily, the first circuit metallization comprises copper, aluminum, or a corresponding alloy. A plurality of first circuit metallizations can be arranged on the first main surface. The plurality of first circuit metallizations is arranged next to each other along a first extension area. The first circuit metallizations are for example separated by isolating grooves.

A metal coating is arranged in the first portion of the first circuit metallization. The second portion of the first circuit metallization is free from the metal coating. Exemplarily, the metal coating of the substrate surface will prevent oxidation and/or corrosion of exposed portions of the first circuit metallization. Arranging the metal coating to certain portions improves joining processes, e.g. by an improved adhesion of the joining material or facilitates the joining process at all. The metal coating is a part of the substrate.

The power semiconductor module further comprises a resin body. The resin body is for example a mold compound. Exemplarily, the resin body is a thermosetting resin or a thermoplastic resin. The resin body comprises for example a filler material of particles, fibers or mesh. Exemplarily, the resin body is manufactured by transfer molding, injection molding, or any other suitable molding method.

The resin body covers the substrate and the first circuit metallization partially. The resin body particularly covers the second portion of the first circuit metallization completely. The first portion of the first circuit metallization is free from the resin body.

The resin body has a top surface extending along the first extension area. The resin body has an inner surface extending along the first extension area and facing the first circuit metallization. The resin body comprises at least one opening extending into the resin body from the top surface to the inner surface along the stacking direction. The at least one opening terminates at the first portion, such that the metal coating is exposed. The metal coating is mainly or entirely exposed. The metal coating is at least partially exposed.

The openings in the resin body are needed for the molding process and/or for mounting of vertically arranged terminals. This results in exposed portions of the substrate surface. To prevent local oxidation and/or corrosion of the first circuit metallization, the metal coating is applied. Additionally, the metal coating improves the joining of terminals to the first circuit metallization depending on the chosen joining technology. In some cases, during the molding process, the pins of the molding tool inside the openings are also needed to press the substrate towards the bottom of a molding tool.

Thus, a further process for closing and sealing the openings with a subsequent filling of the openings, for example by resin material, can be avoided. Consequently, this saves effort and costs.

The metal coating can be applied only on those portions, which are not covered by the resin body. For example, the metal coating is not applied on those portions, where the resin body adheres to the substrate.

Thus, the coating of the complete first circuit metallization can be avoided. Omitting the local metal coating in certain portions, results in an increased adhesion strength between the substrate surface, i.e., the circuit metallization, and the resin body. For example, a metal coating comprising silver, reduces the adhesion strength compared to a bare circuit metallization, which comprises bare copper. An increased adhesion strength results in less mechanical damage, decreased humidity penetration, and finally in an increased reliability of the power semiconductor module compared with a coating of the complete first circuit metallization.

According to a further embodiment the at least one opening has along the first extension area a cross section, which is circular-shaped or rectangular-shaped.

Alternatively, the at least one opening has an elliptically shaped or triangular-shaped cross-section. The at least one opening is not limited to these cross sections and can have a cross section of any polygonal shape. The cross sections of multiple openings can be the same or have different shapes.

According to a further embodiment the at least one opening has a cross section with a first width extending along the first extension area. The first width is the longest distance inside the cross section. For example, the first width is the diameter of a circle. For example, the first width of a square-shaped or rectangular-shaped opening is the diagonal connecting two opposite corners. For example, the first width of an elliptically shaped cross section is the major axis of the ellipsis. For polygonal shaped cross sections, the first width is the longest distance crossing the inside of the cross section between two corners.

The value of the first width of the opening is uniform along the stacking direction. Correspondingly, the area of the cross section of the at least one opening is uniform along the stacking direction. The value of the first width is in the range between 2 mm and 20 mm. The values of 2 mm and 20 mm are included in this range.

The limits of the first width depend on the need of a certain opening size. The size of the opening is given by the type and design of a used terminal. For example, for a pin terminal a first width of 2 mm is sufficient. If there is a power terminal with a horizontal foot extending along the first extension area, a first width of 10 mm or more is needed. Depending on the number of terminals inside one opening, the size of the width is varied.

A larger first width also simplifies closing the opening in the resin body after inserting for example a terminal into the opening. This allows an easy and more reliable processing relating to planting of the terminals.

The size of the first width of the opening also influences the joining processes between terminal and metal coating. Alternatively, the width is determined by the joining process to be applied. The more space is available in the opening, the less complicated the joining process will be for example due to accessibility of the terminal foot. For example, accessibility for welding tools. A square-shaped cross section of the opening is for example more suitable for using a sonotrode to join terminals to the circuit metallization by ultrasonic welding.

According to a further embodiment the at least one opening has a cross section with a second width extending along the first extension area. The second width varies along the stacking direction. For example, the second width decreases from the top surface to the inner surface along the stacking direction. Correspondingly, the area of the cross section of the at least one opening decreases. For example, the sidewalls of the opening taper the second width along the stacking direction. For example, the opening has a truncated cone shape, wherein the diameter at the top surface is larger than the diameter at the inner surface. Alternatively, the opening has a truncated pyramid shape. The opening is not limited to the mentioned shapes and can have any suitable shape depending on the application. With a customizable shape of the opening a variety of joining processes can be used. Terminals can be manufactured according to customer specifications. Thus, more flexibility to choose the shape and dimensions of the planted terminals is possible. Alternatively, the shape of the openings can be adjusted according to the selected terminal type.

According to a further embodiment the first circuit metallization comprises a third portion. The third portion is arranged between the first portion and the second portion along the first extension area. The metal coating is arranged between the first circuit metallization and the resin body, such that the metal coating and the resin body are overlapping along the stacking direction.

The third portion extends from the edge of the first portion to the edge of the second portion. The third portion is defined as the area along the first extension area between the first portion and the second portion. For example, for an opening with a circular shaped cross section, the third portion is annular shaped with a first inner diameter and a second outer diameter extending along the first extension area. For example, the third portion has a second outer diameter, which is larger than the second width at the top surface of the opening.

According to a further embodiment the value of the size of the third portion along the first extension area is in the range between 0.1 mm and 4 mm. The metal coated third portion further improves oxidation and corrosion protection. Terminating the metal coating not at the second portion, where the opening is directly adjacent to the border between the resin body and the first circuit metallization, improves the oxidation and corrosion protection. The metal coating of the third portion ensures that the bottom of the opening, i.e., the first portion, is completely coated by the metal coating even in case of manufacturing tolerances.

According to a further embodiment the metal coating comprises a noble metal or an inert metal. For example, silver, gold or nickel. The metal coating is not limited by the mentioned materials and can comprise any suitable material.

According to a further embodiment the metal coating comprises a plurality of layers arranged along the stacking direction. For example, the metal coating is a multilayer stack with three layers. For example, Nickel, Palladium and Gold arranged from the top to the bottom along the stacking direction. This facilitates better soldering and wetting properties compared to Nickel-Gold layers. Furthermore, one layer of the multilayer stack is used as a diffusion barrier. For example a layer comprising Palladium is used as diffusion barrier.

According to a further embodiment the thickness of the metal coating is in the range between 0.1µm and 20µm.

According to a further embodiment the at least one opening in the resin body is configured to receive at least one first terminal. Alternatively, or additionally the at least one opening is configured to receive at least one second terminal. The first and second terminal electrically couple with the metal coating. The at least one opening has a means to secure planting of the at least one first and/or second terminal at the at least one opening.

According to a further embodiment the at least one first terminal is connected inside the at least one opening directly to the metal coating.

The opening can be left open after contacting the circuit metallization with a pressure contact.

According to a further embodiment the at least one second terminal is connected inside the at least one opening to a reservoir of conductive glue or resin. The conductive glue is provided inside the opening. For example, one first terminal is connected inside one of the at least one opening and one second terminal is connected inside another one of the at least one opening. In this case, there are at least two openings.

The finished power semiconductor module comprises the first and/or second terminal.

The first and second terminal may be solely a pin terminal, or a pin terminal, which is inserted into a hollow sleeve being mounted on the substrate inside the opening to be used as a pin holder. The terminals may have a vertical mounting portion, extending along the stacking direction. Alternatively, or additionally, the terminals may have a horizontal mounting portion, extending in the first extension area, like a terminal foot. The first and second terminal are for example made of copper or copper alloy. Furthermore, a major part of the opening of the resin body can be filled with conductive glue, such that the second terminal is inserted into the glue reservoir. The second terminal is not in direct contact with the substrate or the first circuit metallization or the metal coating. When the conductive glue is hardened the second terminal is electrically and mechanically connected to the substrate. The conductive glue is for example made of epoxy resin as base material, which is filled with silver particles. Other metals can also be used as filler material.

The filling of the opening is done before mounting the terminal. For example, if the terminal is formed by a spring or has a pin shape and the tip penetrates the not yet hardened conductive gel, glue or resin. This can be done depending on the manufacturing method. Alternatively, the opening can be filled with conductive gel, glue or resin, after arranging of the terminal.

The metal coating improves the joining connection between a vertically arranged terminal and the substrate surface depending on the joining technology. The metal coating has a better compatibility with the filled conductive glue for auxiliary signal connection.

There is also provided a method for manufacturing the power package. According to an embodiment the method comprises the step of providing a substrate with a first circuit metallization arranged on a first main surface of the substrate.

In a further step a metal coating is applied on a first portion of the first circuit metallization. Then, the substrate and the first circuit metallization are covered with a resin body by a molding tool during a molding process. The resin body comprises at least one opening. The openings are shaped by pins or protrusions of the mold tool. The pins have the negative shape of the openings. Concurrent with covering the substrate and the first circuit metallization a pressure is applied on the substrate provided by the pins of the mold tool. The pins are pressing the substrate against the bottom of the molding tool. This prevents the substrate backside from contamination with mold resin. In addition, the pressing can provide the flattening of the substrate. The pins of the mold tool are in position before formation of the resin body and are part of the forming tool.

According to a further embodiment, the method comprises the step of inserting at least one first terminal into the at least one opening. The at least one first terminal is joined with the metal coating by soldering, gluing, sintering or welding. After joining of the first terminal, the opening can also be filled with non-conductive glue or resin. Alternatively, the opening is filled, but not cured with a gel, glue or resin, and the terminal is joined with the metal coating before curing.

According to a further embodiment the method comprises the step of at least partially filling the at least one opening with a conductive glue, such that a reservoir of conductive glue is provided. The method further comprises the step of inserting at least one second terminal partly into the reservoir of conductive glue. Then, hardening the conductive glue, such that the at least one second terminal is connected with the reservoir of conductive glue. The terminal can be in touch with the circuit metallization and/or the metal coating. Alternatively, the terminal is not in touch with the circuit metallization and/or the metal coating.

The present disclosure comprises several aspects of a power semiconductor module and of a method for manufacturing a power semiconductor module on the basis of their embodiments and examples. Every feature described with respect to one of the aspects is also disclosed herein with respect to the other aspect, even if the respective feature is not explicitly mentioned in the context of the specific aspect. For example, the method described in this disclosure is directed to a method for manufacturing a power semiconductor module. Thus, features and advantages described in connection with the power semiconductor module can be used for the method, and vice versa.

While the disclosure is amenable to various modifications and alternative forms, specifics thereof are shown by way of example in the figures and will be described in detail. It should be understood, however, that the intention is not to limit the disclosure to the particular described embodiments and examples. On the contrary, the intention is to cover all modifications, equivalents, and alternatives falling within the scope of the disclosure defined by the appended claims.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
- Figure 1 to 3: schematic cross-sectional views of a power semiconductor module according to embodiments,
- Figure 4: a top view of a power semiconductor module according to an embodiment,
- Figure 5 to 7: schematic cross-sectional views of a power semiconductor module according to further embodiments,
- Figure 8: a top view of a power semiconductor module according to a further embodiment,
- Figure 9 to 10: schematic cross-sectional views of a power semiconductor module according to further embodiments.

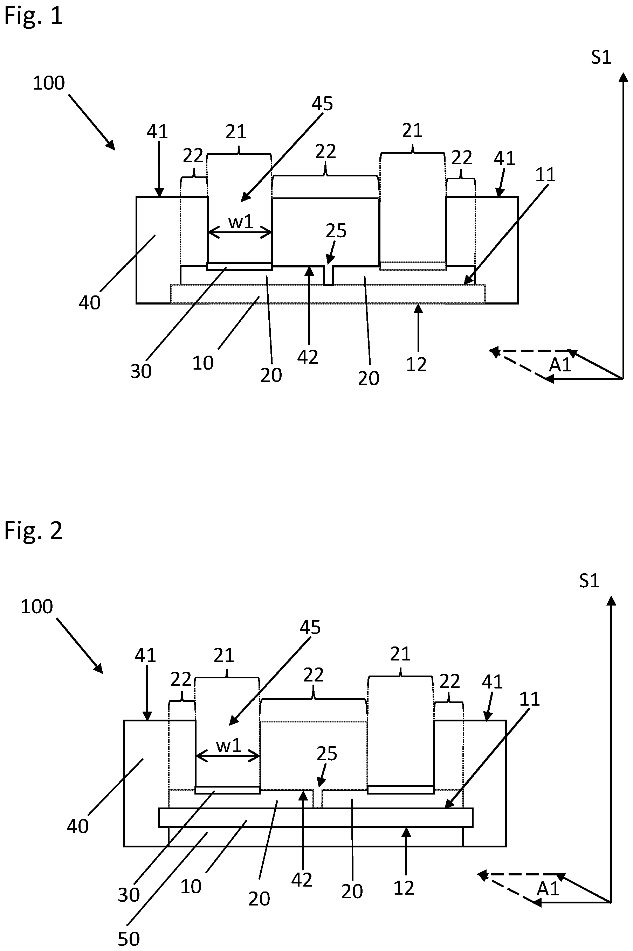

Figure 1 shows a schematic view of a power semiconductor module 100. The power semiconductor module 100 comprises a substrate 10. The substrate is for example isolating. The substrate 10 has a first main surface 11 and a second main surface 12. The second main surface 12 is opposite the first main surface 11 along a stacking direction S1.

A first circuit metallization 20 is arranged on the first main surface 11. The first circuit metallization 20 has a first portion 21 and a second portion 22. A metal coating 30 is arranged in the first portion 21 of the first circuit metallization 20. The second portion 22 is free from the metal coating 30. Exemplarily, the first circuit metallization 20 comprises copper, aluminum, or a corresponding alloy. In Figure 1 two first circuit metallizations 20 are shown, which are arranged on the first main surface 11 next to each other. Between the two first circuit metallizations 20 is a small isolating groove 25. The first circuit metallizations 20 are arranged next to each other along the first extension area. The first circuit metallizations 20 are separated by the isolating groove 25 and are not in mechanical contact to each other.

The power semiconductor module 100 further comprises a resin body 40. The resin body 40 covers the substrate 10 and the first circuit metallization 20 partially. The resin body 40 covers the second portion 22 of the first circuit metallization 20 completely. The first portion 21 of the first circuit metallization 20 is free from the resin body 40.

The resin body 40 has a top surface 41. The top surface 41 extends along a first extension area A1. The stacking direction S1 is for example perpendicular to the first extension area A1. The resin body 40 further has an inner surface 42. The inner surface 42 faces the first circuit metallization 20. The resin body 40 further comprises at least one opening 45. In Figure 1 two openings 45 are shown. The resin body 40 is not limited to exactly two openings 45. Alternatively, the resin body 40 comprises one opening 45 or more than two openings 45. The opening 45 has a uniform first width w1 along the first extension area A1. The value of the first width w1 is in the range between 2 mm and 20 mm.

The opening 45 extends into the resin body 40 from the top surface 41 to the inner surface 42. The opening 45 terminates at the first portion 21 of the first circuit metallization 20. Thus, the metal coating 30 is not covered by the resin body 40. The metal coating 30 is exposed.

Figure 2 shows a schematic view of a power semiconductor module 100 of a further embodiment. The power semiconductor module 100 differs from the power semiconductor module 100 shown in figure 1 in that a second metallization 50 is arranged on the second main surface 12 of the substrate 10.

The second metallization 50 is for example a backside metallization or a heat sink.

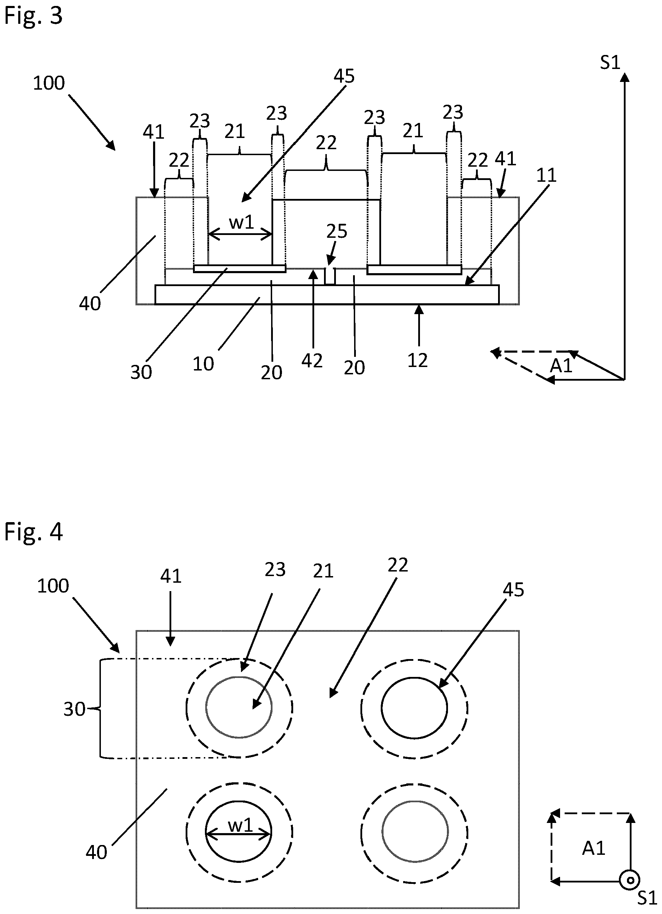

Figure 3 shows a schematic view of a power semiconductor module 100 of a further embodiment. The power semiconductor module 100 differs from the power semiconductor module 100 shown in figure 1 in that the first circuit metallization 20 comprises a third portion 23. The third portion 23 is arranged between the first portion 21 and the second portion 22 along the first extension area A1. In the third portion 23, the metal coating 30 is arranged between the first circuit metallization 20 and the resin body 40, such that the metal coating 30 and the resin body 40 are overlapping along the stacking direction S1.

Figure 4 shows a schematic top view of the power semiconductor module 100 from figure 3. The power semiconductor module 100 comprises the resin body 40 with the top surface 41. The top surface extends along the first extension area A1. In figure 4 four openings 45 are shown.

The power semiconductor module 100 is not limited to four openings 45. The power semiconductor module 100 can have less than four or more than four openings 45. The openings 45 have the first width w1 along the first extension area A1. The power semiconductor module 100 is not limited to the same first width w1 for each opening 45. The first width w1 can vary for each opening 45 if necessary. Inside the opening 45 the portion of the metal coating 30 covering the first portion 21 is visible. The third portion 23 is arranged along the first extension area A1 adjacent to the first portion 21.

The third portion 23 surrounds the first portion 21 along the first extension area A1. The second portion 22 is arranged along the first extension area A1 adjacent to the third portion 23. The second portion 22 surrounds the third portion 23. The metal coating 30 extends in the first portion 21 and in the third portion 23 along the first extension area A1.

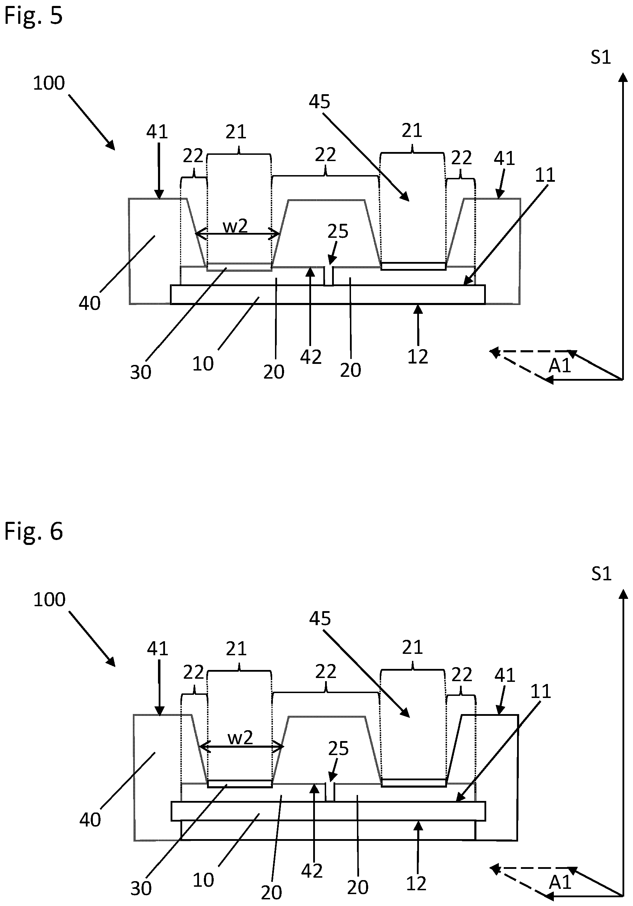

Figure 5 shows a schematic view of a power semiconductor module 100 of a further embodiment. The power semiconductor module 100 differs from the power semiconductor module 100 shown in figure 1 in that the opening 45 has a cross section with a second width w2 extending along the first extension area A1. The second width w2 varies along the stacking direction S1. The second width w2 decreases from the top surface 41 to the inner surface 42 along the stacking direction S1. Correspondingly, the area of the cross section of the opening 45 decreases. For example, the sidewalls of the opening 45 are tapered along the stacking direction S1. The opening 45 has a truncated cone shape, wherein the second width w2 at the top surface 41 is larger than the second width w2 at the inner surface 42. Alternatively, the opening 45 has a truncated pyramid shape. The opening 45 is not limited to the mentioned shapes and can have any suitable shape depending on the application. With a customizable shape of the opening 45 a variety of joining processes can be used.

Figure 6 shows a schematic view of a power semiconductor module 100 of a further embodiment. The power semiconductor module 100 differs from the power semiconductor module 100 shown in figure 5 in that the second metallization 50 is arranged on the second main surface 12 of the substrate 10. The second metallization 50 is for example a backside metallization.

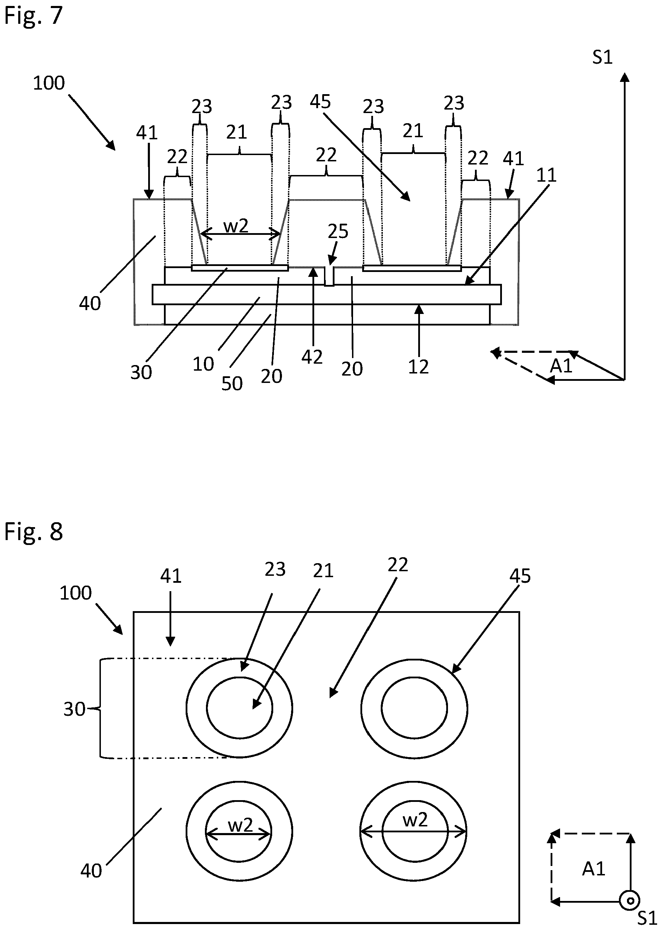

Figure 7 shows a schematic view of a power semiconductor module 100 of a further embodiment. The power semiconductor module 100 differs from the power semiconductor module 100 shown in figure 6 in that the first circuit metallization 20 comprises the third portion 23. The third portion 23 is arranged between the first portion 21 and the second portion 22 along the first extension area A1. In the third portion 23, the metal coating 30 is arranged between the first circuit metallization 20 and the resin body 40, such that the metal coating 30 and the resin body 40 are overlapping along the stacking direction S1. In figure 7 the third portion 23 is equal to the second width w2 at the top surface 41 of the opening 45 along the first extension area A1. Alternatively, the third portion 23 is larger along the first extension area A1 than the second width w2 at the top surface 41 of the opening 45. Alternatively, the third portion 23 is smaller along the first extension area A1 than the second width w2 at the top surface 41 of the opening 45. Alternatively, no second metallization 50 is provided for the power semiconductor module 100.

Figure 8 shows a schematic top view of the power semiconductor module 100 from figure 7. The power semiconductor module 100 comprises the resin body 40 with the top surface 41. The top surface 41 extends along the first extension area A1. In figure 8 four openings 45 are shown. The power semiconductor module 100 is not limited to four openings 45. The power semiconductor module 100 can have less than four or more than four openings 45. The openings 45 have the varying second width w2 along the first extension area A1. The power semiconductor module 100 is not limited to the same varying second width w2 for each opening 45. Exemplarily, each opening 45 can have a different varying second width w2. For example, the second width w2 differs for each opening 45 at the top surface 41. Alternatively, or additionally the second width w2 differs for each opening 45 at the inner surface 42. For example, the second width w2 at the top surface 41 is the same for each opening 45 and differs at the inner surface 42 for each opening 45. The opening 45 is not limited to the mentioned shapes and can have any suitable shape depending on the application. With a customizable shape of the opening 45 a variety of joining processes can be realized.

Inside the opening 45 the portion of the metal coating 30 covering the first portion 21 is visible. The third portion 23 is arranged along the first extension area A1 adjacent to the first portion 21. The third portion 23 surrounds the first portion 21 along the first extension area A1. The second portion 22 is arranged along the first extension area A1 adjacent to the third portion 23. The second portion 22 surrounds the third portion 23. The metal coating 30 extends in the first portion 21 and in the third portion 23 along the first extension area A1. In figure 8 the extent of the third portion 23 along the first extension area is equal to the second width w2 at the top surface 41.

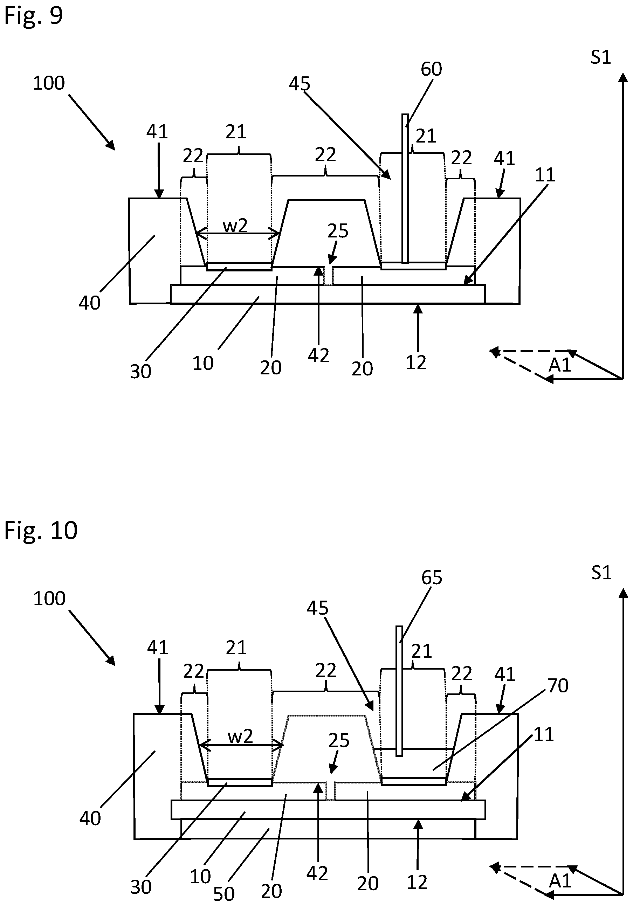

Figure 9 shows a schematic view of a power semiconductor module 100 of a further embodiment. The power semiconductor module 100 differs from the power semiconductor module 100 shown in figure 5 in that the power semiconductor module 100 comprises a first terminal 60. The opening 45 in the resin body 40 is configured to receive at least one first terminal 60. The first terminal 60 is electrically coupled with the metal coating 30 and consequently with the first circuit metallization. The first terminal 60 is connected inside the opening 45 directly to the metal coating 30. The opening 45 has a means to secure the planting of the at least one first terminal 60 at the opening 45. The connection may be facilitated by gluing, soldering, sintering, or welding. The opening 45 can also be filled with gel, glue or resin, after mounting of the first terminal 60.

Figure 10 shows a schematic view of a power semiconductor module 100 of a further embodiment. The power semiconductor module 100 differs from the power semiconductor module 100 shown in figure 9 in that the opening 45 is configured to receive at least one second terminal 65. The second terminal 65 is electrically coupled with the metal coating 30. The opening 45 has a means to secure planting of the second terminal 65 at the opening 45. The second terminal 65 is connected inside the opening 45 to a reservoir of conductive glue or resin 70. The conductive glue is provided inside the opening 45. The second terminal 65 may be in mechanical contact with the metal coating 30. Alternatively, the second terminal 65 is not in mechanical contact with the metal coating 30.

The first terminal 60 and the second terminal 65 may be solely a pin terminal, or a pin terminal, which is inserted into a hollow sleeve being mounted on the substrate 10 to be used as a pin holder. Alternatively, or additionally, the terminals 60, 65 may have a horizontal mounting portion, like a terminal foot. The first terminal 60 and the second terminal 65 are for example made of copper or copper alloy. Furthermore, a major part of the opening 45 of the resin body 40 can be filled with conductive glue, such that the second terminal 65 is inserted into the glue reservoir 70. The second terminal 65 is not in direct contact with the substrate 10 or the first circuit metallization 20 or the metal coating 30. When the conductive glue is hardened the second terminal 65 is electrically and mechanically connected to the substrate 10. The conductive glue is for example made of epoxy resin as base material, which is filled with silver particles. Other metals can also be used as filler material. Alternatively, the opening 45 is filled with gel, glue or resin, after arranging of the second terminal 65.

The metal coating 20 improves the joining connection between a vertically arranged terminal 60, 65 and the substrate 10 depending on the joining technology. The metal coating 30 has a better compatibility with the filled conductive glue for auxiliary signal connection. In addition, the metal coating 30 prevents the top surface of the circuit metallization 20 from oxidation and corrosion.

The partial metal coating 30 supports the mounting of the terminals 60, 65 in the openings 45. On one hand, the metal coating 30 improves the joining connection between a vertically arranged terminal 60, 65 and the substrate 10 depending on the joining technology. On the other hand, a major part of the opening 45 of the resin body 40 can be filled with conductive glue, such that the second terminal 65 is inserted into the glue reservoir 70 and electrically and mechanically connected, when the glue has been hardened. The second terminal 65 will not get in direct contact with the substrate 10. The conductive glue is for example made of epoxy resin as base material, which is filled with silver particles. Other metals can also be used as filler material. The partial silver coating 30 improves the material compatibility of such glue towards the substrate 10.

The opening 45 is not limited to receive one terminal 60, 65. The opening 45 can receive several terminals 60, 65 depending on the necessity of the application. The terminals 60, 65 can be manufactured according to customer specifications. The power semiconductor module 100 may incorporate suitable terminals 60, 65 of different designs. Thus, more flexibility to choose the shape and dimensions of the planted terminals is possible. Furthermore, the opening 45 can be filled with gel, glue or resin before or after arranging and mounting of the terminals 60, 65.

Furthermore, the power semiconductor module 100 in figure 10 comprises a second metallization 50. The second metallization 50 is for example a backside metallization. The second metallization 50 is optional and can be also omitted.

The embodiments shown in the Figures 1 to 10 as stated represent exemplary embodiments of the power semiconductor module; therefore, they do not constitute a complete list of all embodiments according to the power semiconductor module. Actual arrangements and methods may vary from the embodiments shown in terms of arrangements, devices and methods for example.

### Reference Signs

- 100: Power semiconductor module
- 10: substrate
- 11: first main surface
- 12: second main surface
- 20: first circuit metallization
- 21: first portion
- 22: second portion
- 23: third portion
- 25: isolating groove
- 30: metal coating
- 40: resin body
- 41: top surface
- 42: inner surface
- 45: opening
- 50: second metallization
- 60: first terminal
- 65: second terminal
- 70: reservoir of conductive glue

- S1: stacking direction
- A1: extension area
- w1: first width
- w2: Second width

## Claims

1. Power semiconductor module (100) comprising
- a substrate (10), having a first main surface (11) and a second main surface (12) opposite the first main surface (11) along a stacking direction (S1),
- a first circuit metallization (20) with a first portion (21) and a second portion (22), arranged on the first main surface (11),
- a metal coating (30) arranged in the first portion (21) of the first circuit metallization (20),
- a resin body (40) covering the substrate (10) and the second portion (22) of the first circuit metallization (20), wherein the resin body (40) has a top surface (41) extending along a first extension area (A1), and an inner surface (42) facing the first circuit metallization (20), and wherein
- the resin body (40) comprises at least one opening (45) extending into the resin body (40) from the top surface (41) to the inner surface (42) along the stacking direction (S1), terminating at the metal coating (30), such that the metal coating (30) is exposed.

2. Power semiconductor module (100) according to claim 1, wherein the at least one opening (45) has along the first extension area (A1) a cross section, which is circular-shaped or rectangular-shaped.

3. Power semiconductor module (100) according to claim 1 or 2, wherein the at least one opening (45) has a cross section with a first width (w1) extending along the first extension area (A1), which is uniform along the stacking direction (S1), wherein the value of the first width (w1) is in the range between 2 mm and 20 mm.

4. Power semiconductor module (100) according to claim 1 or 2, wherein the at least one opening (45) has a cross section with a second width (w2) extending along the first extension area (A1), which varies along the stacking direction (S1), wherein the second width (w2) decreases from the top surface (41) to the inner surface (42) along the stacking direction (S1) .

5. Power semiconductor module (100) according to any of the preceding claims, wherein the first circuit metallization (20) comprises a third portion (23) arranged between the first portion (21) and the second portion (22) along the first extension area (A1), and in which the metal coating (30) is arranged between the first circuit metallization (20) and the resin body (40), such that the metal coating (30) and the resin body (40) are overlapping along the stacking direction (S1).

6. Power semiconductor module (100) according to claim 5, wherein the value of the size of the third portion (23) along the first extension area (A1) is in the range between 0.1 mm and 4 mm.

7. Power semiconductor module (100) according to any of the preceding claims, wherein the metal coating (30) comprises a noble metal or an inert metal.

8. Power semiconductor module (100) according to any of the preceding claims, wherein the metal coating (30) comprises a plurality of layers arranged along the stacking direction (S1) .

9. Power semiconductor module (100) according to any of the preceding claims, wherein the thickness of the metal coating is in the range between 0.1µm and 20µm.

10. Power semiconductor module (100) according to any of the preceding claims, wherein the at least one opening (45) in the resin body (40) is configured to receive at least one first terminal (60) and/or at least one second terminal (65) that electrically couples with the metal coating (30) and has a means to secure planting of the at least one first terminal (60) and/or second terminal (65) at the at least one opening (45) .

11. Power semiconductor module (100) according to claim 10, wherein the at least one first terminal (60) is connected inside the at least one opening (45) directly to the metal coating (30).

12. Power semiconductor module (100) according to any of the preceding claims, wherein the at least one second terminal (65) is connected inside the at least one opening (45) to a reservoir of conductive glue (70).

13. Method of manufacturing the power semiconductor module (100) according to any of the preceding claims, comprising
- providing a substrate (10) with a first circuit metallization (20) arranged on a first main surface (11) of the substrate (10),
- applying a metal coating (30) on a first portion (21) of the first circuit metallization (20),
- covering the substrate (10) and the first circuit metallization (20) with a resin body (40) comprising at least one opening (45) by a mold tool, concurrent with
- applying pressure on the substrate (10) provided by pins or protrusions of the mold tool, which are inserted through the at least one opening (45), such that the substrate (10) is flattened.

14. Method according to claim 13, comprising
- inserting at least one first terminal (60) into the at least one opening (45) and
- joining the at least one first terminal (60) with the metal coating (30) by soldering, gluing or welding.

15. Method according to claim 13 or 14, comprising
- at least partially filling the at least one opening (45) with a conductive glue, such that a reservoir of conductive glue (70) is provided,
- inserting at least one second terminal (65) partly into the reservoir of conductive glue (70),
- hardening the conductive glue, such that the at least one second terminal (65) is connected with the reservoir of conductive glue (70).
